# EUROPEAN PATENT SPECIFICATION

(11) **EP 3 989 296 B1**
(45) Date of publication and mention of the grant of the patent: **07.09.2022**
(21) Application number: 21202426.9
(22) Date of filing: 13.10.2021
(51) Int. Cl.: H01L 31/18, H01L 31/048

(54) **METHOD, PLANT AND APPARATUS FOR RECYCLING PHOTOVOLTAIC PANELS**
VERFAHREN, ANLAGE UND VORRICHTUNG ZUM RECYCLING VON PHOTOVOLTAISCHEN PANEELEN
MÉTHODE, INSTALLATION ET APPAREIL POUR LE RECYCLAGE DES PANNEAUX PHOTOVOLTAÏQUES

(30) Priority: 14.10.2020 IT 202000024277
(43) Date of publication of application: 27.04.2022
(73) Proprietor: 9-Tech S.r.l., 30020 Eraclea (VE) (IT); Veneziana Energia Risorse Idriche Territorio Ambiente Servizi- V.E.R.I.T.A.S. S.p.A., 30135 Venezia (IT)
(72) Inventor: Cerchier, Pietrogiovanni, 30020 Eraclea (VE) (IT); Nisato, Francesco, 30038 Spinea (VE) (IT); Pezzato, Luca, 36015 Schio (VI) (IT); Tassinato, Graziano, 35129 Padova (IT)
(74) Representative: Di Bernardo, Antonio

(56) References cited:
- WO-A1-2008/102457
- WO-A1-2015/092734
- WO-A1-2019/087111
- CN-A- 109 092 842
- US-A- 3 790 091

## Description

### TECHNICAL FIELD

The present invention relates to the sector of plants for recycling photovoltaic panels. In particular, the invention relates to a recycling method, to a plant capable of implementing this method as well as to an apparatus used in such a plant.

### BACKGROUND

Photovoltaic panels essentially consist of a frame which encloses a sandwich of materials containing the photovoltaic cells. In detail, the sandwich is typically composed of a transparent glass that allows the passage of sunlight, a junction insulating plate, typically made of EVA (Ethylene Vinyl Acetate), a layer consisting of photovoltaic cells, a further junction insulating plate made of EVA and, finally, a rear support plate (called backsheet), generally made of insulating material with reduced thermal expansion such as e.g. Polyvinyl fluoride (PVF) or Polyethylene Terephthalate (PET).

After the separation of the frame from the sandwich, the recycling methods essentially provide for three treatment steps: a step aimed at detaching the glass from the silicon cells and the backsheet, a step aimed at separating the materials thus obtained (in particular the photovoltaic cells or portions thereof), and a step employing a chemical type process, suitable for the extraction of silver and for the purification of the silicon from the cells.

In order to carry out the first separation step, the most common plants for recycling photovoltaic panels implement mechanical type treatment methods, in which the panels are ground and the materials separated through different techniques (e.g. vibrating tables, optical reader). However, if the panel is fully ground, the purity of the glass is contaminated, as part of the EVA remains adherent to the glass. Furthermore, the remaining fraction of the module is reduced into very small pieces and the materials present in the photovoltaic cells are not recovered. In more advanced versions, the glass is removed from the panel with blades, in some solutions by softening the EVA by heating it, thus obtaining the glass and the remaining sandwich part (EVA, cells and backsheet). However, the separation of the glass is not efficient as part of the glass may remain joined to the sandwich or EVA portions are detached with the glass. In addition, the photovoltaic cells, despite remaining inside the sandwich, are broken into small pieces. The reduction of the photovoltaic cells into small pieces compromises: an effective separation thereof from the remaining material (therefore the efficiency of the recovery), the possibility of easily treating the cells chemically, the quantity of silicon that is lost during the chemical treatment (increasing the exposed surface/treated volume) and the purity of the silicon that can be obtained.

An alternative method to the mechanical one is the chemical method, whereby EVA is dissolved with chemical reagents (typically organic solvents). These methods have on the one hand the limitation of the dangerousness of the reagents used, on the other hand the fact that they too do not allow the cells of the photovoltaic panel to be valorised. In fact, the solvent used causes the EVA to swell (a phenomenon known as "swelling") which causes the panel to deform in such a way as to break the fragile photovoltaic cells.

The drawback of obtaining silicon in small fragments can be overcome by using alternative methods such as the polymer combustion or pyrolysis. Between the two methods, however, pyrolysis is more complex, with higher costs and furthermore, the presence of the fluorinated polymer complicates the purification of the obtained syngas.

Therefore, in order to valorise the greater quantity of materials present in the panels, the methods currently mostly used provide for the implementation of a heat type treatment through which a combustion of the polymer (of the junction insulating plates as well as of the rear support plate) is obtained; however, this method has some limitations, in particular if it is implemented on a small scale since, despite a greater valorisation of the materials deriving from the disposal of the panel, it entails operating costs that are considerably higher than the aforementioned mechanical type method, mainly due to the energy expenditure linked to the thermal treatment used.

Furthermore, although with this method the cells are recovered without being fragmented, the combustion of the backsheet leaves titanium oxide or barium sulphate powder as a residue, which contaminates the surface thereof and risks compromising the purity of the recovered silicon (the purity required by the market depends on the type of application) and of the glass.

The removal of the backsheet before the heat treatment is difficult as it is strongly bonded to the EVA and the glass, which is typically broken, complicates the mechanical separation. On the other hand, this operation also involves serious damages to the silicon cells to be recovered.

As mentioned above, following this first treatment step, the recycling plants provide for suitable processes aimed at separating the different types of materials obtained following the thermal or mechanical treatments mentioned above.

To this end, some plants implement systems using vibrating tables or belts, which often rely on the difference in specific weight between the two materials in order to carry out the separation. However, these systems are not suitable for an efficient separation of glass from silicon, as the specific weight of these materials is very similar.

In still other plants, separators of the optical type are used or those which exploit the electrical or magnetic conductivity characteristics of the materials to be separated, such as eddy current separators. These methods are more efficient than those using vibrating surfaces but, in any case, they do not satisfactorily separate the silicon particles from the glass, as these materials are both not very conductive and non-ferromagnetic; the plants using these methods also involve a rather significant manufacturing and operational cost, as well as require a careful maintenance.

A further method used for the separation of glass and silicon is based on the use of a jet of fluid, according to various possible configurations, incident on these materials. Such separation systems of the aeraulic type can, however, result in an inaccurate separation of the materials, as the thinnest glass fragments may remain in the silicon cells and consequently entail the need to provide for a further sieving step, and therefore an extension of process times and therefore of the costs associated therewith. Furthermore, the plants in which these methods are used are generally rather bulky and require a good suction system in order to avoid dispersion of the dusts into the environment.

Documents WO 2019/087111, CN 109 092 842, US 3,790,091, WO 2008/102457 and WO 2015/092734 disclose solutions for recycling solid waste, in particular photovoltaic panels.

There is therefore a need for a plant and a method for recycling photovoltaic panels in which the processes implemented therein have improved efficiency and whose manufacturing and management are cost-effective.

### OBJECTS AND SUMMARY OF THE INVENTION

An object of the present invention is to overcome the drawbacks of the prior art. 2. The subject matter of the present invention is defined in independent claims 1, 5 and 11.

In particular, it is an object of the present invention to present a method and a plant for recycling photovoltaic panels endowed with improved efficiency.

It is also an object of the present invention to present a method and apparatus which allow to reliably and efficiently separate the glass from the silicon of the photovoltaic panel.

A further object of the present invention is to present a plant for recycling photovoltaic panels whose energy efficiency is improved.

A further object of the present invention is to present a plant and an apparatus for recycling photovoltaic panels whose construction and management are overall cheaper than the plants of the prior art.

Finally, the object of the present invention is to present a method, a plant and an apparatus for recycling photovoltaic panels which makes it possible to optimise the times to carry out the entire recycling process and the quality of the recovered material.

These and other objects of the present invention are achieved by a method and apparatus incorporating the features of the appended claims, which form an integral part of the present description.

In accordance with a first aspect, the invention relates to a method for recycling photovoltaic panels of the type formed by a frame which encloses a sandwich comprising a glass plate connected to a plurality of photovoltaic cells by means of a first junction insulating plate, wherein the photovoltaic cells comprise silicon elements and metal contacts wherein the method comprises the action of removing the frame and any electrical components from the photovoltaic panel, so as to take a sandwich comprising a glass, a first junction insulating plate, the photovoltaic cells, a second junction insulating plate and a rear support plate. The method further provides for subjecting the sandwich to heat treatment in a furnace until the sandwich is broken up into a first set of materials comprising glass elements, silicon elements and metal contacts, and for separating the metal contacts from the first set of materials so as to obtain a second set of materials comprising glass elements and silicon elements. The method further provides for sliding the second set of materials along an inclined planar element having at least one pair of side guides and one or more conveyor elements which are arranged along an upper surface of the planar element so as to form one or more slits configured to separate the silicon elements from the glass elements.

According to this solution, it is possible to reliably and efficiently separate the glass elements, even of small dimensions, from the silicon elements deriving from the dissociation of a photovoltaic panel, thereby optimising both the quantity and the quality of the recycled materials.

In accordance with a second aspect, the invention relates to a plant for recycling photovoltaic panels of the type formed by a frame which encloses a sandwich comprising a glass plate connected to a plurality of photovoltaic cells by means of a first junction insulating plate, wherein the photovoltaic cells comprise silicon elements and metal contacts, the plant comprising at least one treatment apparatus extending between a loading zone and an unloading zone and configured to perform an initial break-up of the sandwich, and at least one separation apparatus extending between its own inlet section and its own outlet section, and configured to perform a separation of glass elements from silicon elements. The separation apparatus is served by at least one treatment apparatus and has its own inlet section in proximity to the unloading zone of the treatment apparatus. The separation apparatus further comprises an inclinable planar element having at least one pair of side guides and one or more conveyor elements which are arranged along an upper surface of the planar element so as to form one or more slits configured to separate the silicon elements from the glass elements.

This solution makes it possible to obtain a plant in which the process for recycling photovoltaic panels is highly efficient and at the same time the manufacturing and management of the plant is cost-effective. This plant is also extremely versatile, as it is conveniently suitable for numerous modifications thanks to the possibility of decoupling the apparatuses present therein, and further allows a simplified management of the maintenance operations.

In accordance with a further aspect, the invention relates to a separation apparatus for recycling photovoltaic panels of the type formed by a frame which encloses a sandwich comprising a glass plate connected to a plurality of photovoltaic cells by means of a first junction insulating plate, wherein the photovoltaic cells comprise silicon elements and metal contacts, the apparatus comprising at least one inclinable planar element having at least one pair of side guides and one or more conveyor elements of substantially laminar shape, which are arranged along an upper surface of the planar element so as to form one or more slits configured to separate the silicon elements from the glass elements.

According to this solution, it is possible to obtain an apparatus for the separation of glass elements from silicon elements that is structurally simple and robust, while at the same time it allows optimising the times for performing the separation process, as well as the quality of the material recovered.

The present invention may have, in at least one of the aforesaid aspects, at least one of the following preferred features, taken individually or combined with any one of the other preferred features described.

Preferably, the action of separating the metal contacts from the first set of materials is done mechanically. This action comprises conveying the first set of materials towards a mechanical separator device configured to allow the passage of glass and silicon elements, so as to separate them from the metal contacts. For example, the mechanical separator device may comprise a comb-like element comprising a plurality of lamellae which are mutually parallel and spaced apart between them.

Preferably, downstream of the step of separating the metal contacts, the method provides for a step of removing the partially combusted elements of the rear support plate, so as to separate them from the photovoltaic cells. Preferably, said step of separating the partially combusted elements is carried out by means of a suction device.

In this way, a further selection of the materials is carried out, allowing the elements that are subjected to subsequent processing steps to be purified even more.

Preferably, the step of sliding the second set of materials along a planar element is preceded by a sifting of said second set, by means of a vibrating sieve, configured so as to provide for a separation of elements having a maximum size of less than or equal to about 2 mm.

This operation advantageously makes it possible to provide, according to simple and economical, but at the same time effective ways, for a filtration of small glass elements up to dust particle sizes, so as to prevent the finest particles from entering the slits, thus contaminating the silicon or obstructing the slits suitable for the glass/silicon separation in the subsequent processing step.

Preferably, the step of sliding the second set of materials along the inclined planar element comprises the step of oscillating the planar element in a lateral direction.

This promotes the advancement of the material along the upper surface of the planar element.

Preferably, the plant comprises a mechanical separator device, placed downstream of the treatment apparatus, configured to allow the passage of the glass and silicon elements, so as to separate them from the metal contacts. For example, the mechanical separator device may comprise a comb-like element that comprises a plurality of lamellae which are mutually parallel and spaced apart between them so as to form a plurality of openings adapted to allow the passage of the glass and silicon elements, so as to separate them from the metal contacts.

According to this configuration, it is possible to have a device whose construction and management is simple, which ensures the efficiency of the process of separating the metal contacts, which are separated from the flow of the material by sliding on the lamellae.

Preferably, the lamellae are placed at a mutual distance the value of which is less than about 50 mm.

In this way, optimal conditions are created so that the process of separating the metal elements is carried out efficiently.

Preferably, in a position lower than the mechanical separator device there are a first collecting element, into which the metal contacts separated by means of the mechanical separator device fall and are collected, as well as a second collecting element, adapted to receive the material exiting the treatment apparatus, deprived of metal contacts, falling from the mechanical separator device.

Preferably, the separation apparatus comprises a vibrating sieve, placed at the inlet section, and configured so as to provide for a separation of elements having a maximum size of less than or equal to about 2 mm.

According to this configuration, a preliminary filtration of the small-sized glass elements is effectively carried out in a simple and economical way, so as to increase the efficiency of the subsequent separation step.

Preferably, the planar element has a plurality of openings, in proximity of each of which a respective conveyor element is arranged, which extends parallel to the planar element and is placed at a distance, substantially constant, from a plane containing the upper surface of the planar element. Preferably, said distance has a value less than or equal to about 2 mm.

Preferably, the conveyor elements are placed at a distance from the inlet section of the conveyor apparatus greater than or equal to about 100 mm.

According to this configuration, the effectiveness of the separation of the glass from the silicon is optimised as the cells are arranged by gravity parallel to the plane along the descent on the inclined plane, this orientation combined with the careful sizing and positioning of the slits formed by the plane and conveyor elements, allows the passage of the silicon elements alone, through the slits thus constituted.

Preferably, the conveyor elements are connected to the planar element by means of fixing means.

Preferably, said fixing means are configured in such a way as to allow an adjustment of the distance of the conveyor elements from a plane passing through the upper surface of the planar element.

In a preferred embodiment, said fixing means comprise washers and/or shims.

In this way, it is advantageously possible to maintain the appropriate distance between the conveyor elements and planar element.

Furthermore, this allows the separation apparatus to be advantageously adapted to the type of material being processed.

Preferably, the separation apparatus comprises at least one central conveyor element and at least one pair of side conveyor elements, each of which is arranged on the upper surface so as to present an apex facing towards the inlet section.

According to this configuration, the side conveyor elements allow to separate the falling material along the upper surface, and at the same time to guide it conveniently in the direction of the central conveyor element. Furthermore, the relative position of the apex facilitates the sliding of the material being processed along the upper surface, thus avoiding unwanted blockages or obstructions in the flow.

Preferably, the conveyor elements have a convex polygonal shape.

Preferably, the central conveyor element is conformed according to a convex pentagon, formed by the juxtaposition of a pair of rectangular trapezoids along their major base. Preferably, the side conveyor elements are conformed according to a rectangular trapezium having its major base adjacent to the respective side guide.

This configuration conveniently makes it possible to ensure that all of the photovoltaic cells or portions thereof are intercepted in the downward path along the planar element and therefore that the glass and silicon elements are efficiently separated.

The separation apparatus further comprises a movement device configured to impose on the planar element a unidirectional oscillatory motion according to a lateral direction.

This promotes the advancement of the material along the upper surface of the planar element during the separation step. In addition, the absence of vertical movement prevents the material from separating from the planar element during the descent avoiding intercepting the slits.

Preferably, at least one conveyor element is constrained to the planar element in such a way that it can oscillate with respect to the latter in a lateral direction perpendicular to a longitudinal axis of the planar element.

This makes it possible to prevent silicon elements from getting caught in the slits and obstructing the passage thereof.

Preferably, the conveyor elements are made of sheet metal having a thickness of at least 2 mm.

This makes it possible to ensure the necessary rigidity to prevent any deformations and thus guarantee the parallelism between the conveyor element and the external surface of the planar element, so that the slits present remain open during the use of the separation apparatus over time.

Preferably, the planar element is made of sheet metal having a thickness of at least 2 mm.

Preferably, the separation apparatus comprises reinforcing means connected to the planar element.

Preferably, said reinforcing means are placed in a lower position of the planar element, in at least partial connection with a lower surface thereof.

This allows to avoid undesirable bending and/or deformations of the planar element so as not to incur undesirable obstructions in the opening of the slits.

Further features and advantages of the present invention will be more evident from the description of the accompanying drawings.

### BRIEF DESCRIPTION OF THE DRAWINGS

The invention is described hereinbelow with reference to certain examples provided by way of non-limiting example and illustrated in the accompanying drawings. These drawings illustrate different aspects and embodiments of the present invention and reference numerals illustrating structures, components, materials and/or similar elements in different drawings are indicated by similar reference numerals, where appropriate. Moreover, for clarity of illustration, certain references may not be repeated in all drawings.
Figure 1 is a schematic perspective view of the plant for recycling photovoltaic panels according to an embodiment of the present invention;
Figure 2 is a side view of the plant of Figure 1;
Figure 3a shows a schematic top view of a detail of the plant of Figure 1, according to a variant;
Figure 3b shows a schematic view from below of the detail of Figure 3a;
Figure 3c shows an enlarged view of a possible embodiment of the detail marked with c of Figure 3a;
Figure 4 shows an exploded view of a recyclable photovoltaic panel in the plant of Figure 1;
Figure 5a shows a side schematic view of a portion of the plant of Figure 1, according to a first embodiment, with some parts removed to better point up others;
Figure 5b shows a schematic side view of the portion of the plant shown in Figure 5a, according to an alternative embodiment, with some parts removed to better point up others;
Figure 6 shows a diagram of a first treatment step implemented by the plant of Figure 1, according to the invention;
Figure 7 shows a diagram of a further treatment step implemented by the plant of Figure 1, according to the invention; and
Figure 8 is a flow chart of a method for recycling photovoltaic panels, implemented by the plant according to the invention.

### DETAILED DESCRIPTION OF THE INVENTION

While the invention is susceptible to various modifications and alternative constructions, certain preferred embodiments are shown in the drawings and are described hereinbelow in detail. It must in any case be understood that there is no intention to limit the invention to the specific embodiment illustrated, but, on the contrary, the invention intends covering all the modifications, alternative and equivalent constructions that fall within the scope of the invention as defined in the claims.

The use of "for example", "etc.", "or" indicates non-exclusive alternatives without limitation, unless otherwise indicated. The use of "comprises" and "includes" means "comprises or includes, but not limited to", unless otherwise indicated.

The term "clearance" refers to the minimum distance between two elements, suitable for the passage of a flow of material.

The term "apex" of a geometric figure refers to its upper vertex, i.e. the vertex situated at a greater height than the ground.

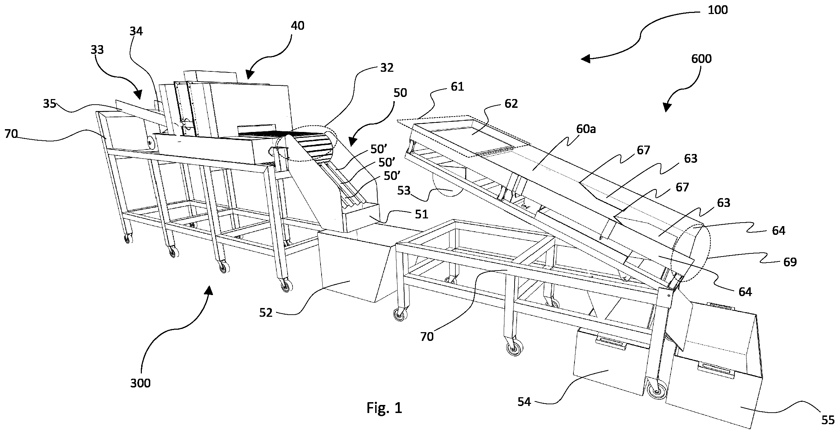

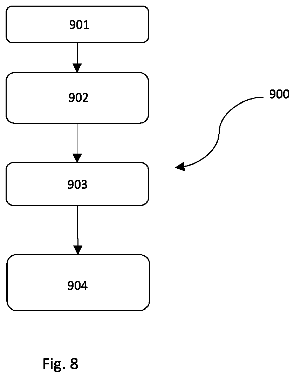

With reference to Figure 1, a plant for recycling photovoltaic panels - indicated with reference 100 - capable of implementing the method of Figure 8 is schematically illustrated.

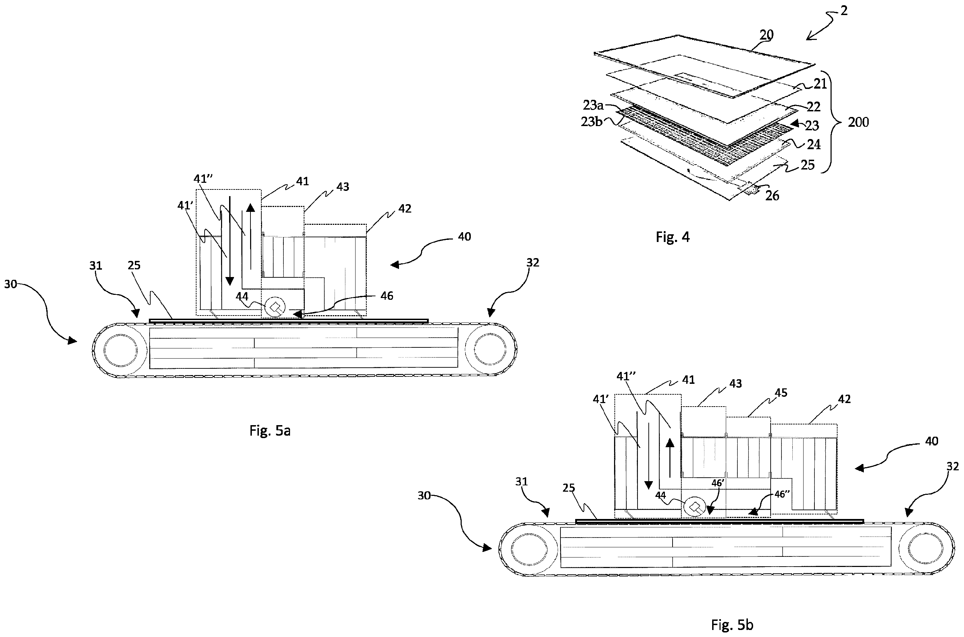

An example of a photovoltaic panel 2 that can be treated in the plant 100 is illustrated in Figure 4, which shows an exploded view thereof. The panel consists of a frame 20 which encloses a sandwich 200. The sandwich 200 comprises a transparent glass plate 21, a first junction insulating plate 22 (e.g., of EVA), a layer of photovoltaic cells 23, a second junction insulating plate 24, and a rear support plate (called backsheet) 25 generally made of Polyethylene terephthalate (PET) and Polyvinyl fluoride (PVF) or other insulating material characterized by a good resistance to atmospheric ageing. The panel further comprises some electrical components 26, in particular connectors and cables. Since the photovoltaic panels are known per se, we will not go into more detail here in the description of the photovoltaic panel 2, limiting ourselves to specifying that the photovoltaic cells 23 comprise silicon elements 23a and metal contacts 23b.

The plant 100 comprises at least one treatment apparatus 300 adapted to carry out initial dismemberment processings of the components of the photovoltaic panel 2, in particular of the junction plates 22, 24 and of the metal contacts 23b from the sandwich 200; the plant 100 further comprises at least one separation apparatus 600 adapted to separate the remaining components, that is, the silicon elements 23a from glass elements 21' resulting from the fragmentation of the glass plate 21.

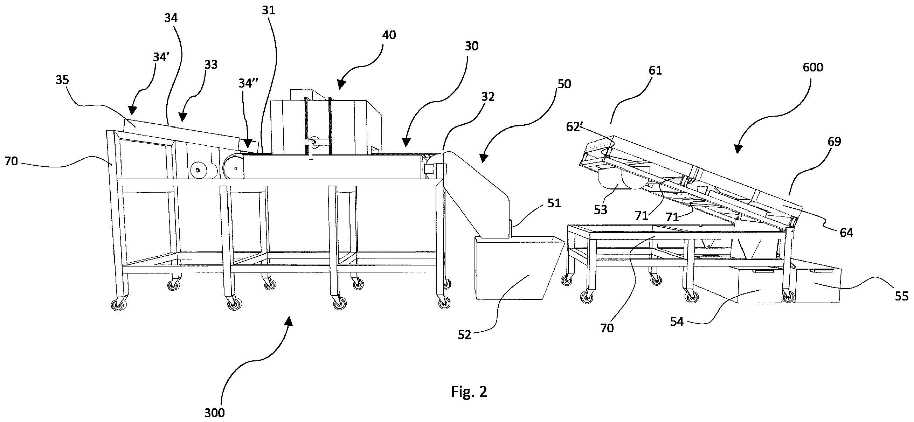

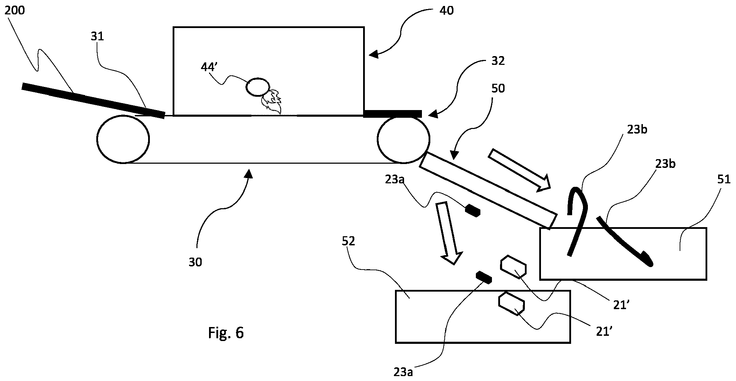

The treatment apparatus 300, as shown in Figures 2, 5 and 6, comprises a feeding device 30 adapted to transport material from a loading zone 31 to an unloading zone 32 through at least one processing station.

In a preferred embodiment, the feeding device 30 consists of a conveyor belt. This feeding device 30 is connected to an actuation device (not shown in the figures), such as for example a gearmotor, which allows the continuous or intermittent motion thereof as well as the possibility of varying its advancement speed at will, so as to transport the sandwich 200 or portions thereof, through the processing station.

According to a preferred embodiment, the feeding device 30 is advantageously connected to a loading device 33 adapted to receive the sandwiches 200 or portions of them to be treated, and to facilitate their loading onto the loading zone 31 of the feeding device 30. Preferably, said loading device 33 comprises an inclined chute 34 having a first end portion 34' - preferably placed at a height suitable for loading the panels by an operator - as well as a second end portion 34" placed in proximity to the loading zone 31 of the feeding device 30. Preferably, said loading device 33 comprises sideboards 35 which advantageously allow to convey and support the sandwiches 200 arranged on the inclined chute 34, during their sliding motion towards the feeding device 30. According to a preferred embodiment, such an inclined chute 34 is provided with idle rollers to facilitate the descent of the sandwich 200.

The treatment apparatus 300 further comprises, as mentioned, at least one processing station provided with at least one furnace 40, which is configured to subject the sandwich 200 to a temperature that allows it to be partially dismembered.

More particularly, as shown for example in Figures 5a and 5b, the furnace 40 is a continuously operating tunnel furnace, arranged astride the feeding device 30 and configured to allow the passage thereof along a path that crosses it, placed at its base portion.

The furnace 40 preferably comprises a heater device 44 configured to generate a directional heat flow, in particular a heat flow directed towards an upper surface of the sandwich 200. The heater device 44 may comprise one or more among a gas burner 44', means suitable for generating a directional flow of hot air and/or a flow of infrared rays.

According to a preferred embodiment, as shown in Fig. 5a, the furnace 40 is advantageously gas-fired and comprises a fume inlet and outlet module 41, a closing head 42, a thermal unit 43 comprising a burner 44' and configured to constitute a combustion chamber 46.

According to an alternative embodiment, as shown in Fig. 5b, the furnace 40 is gas-fired and comprises a fume inlet and outlet module 41 which is connected to a thermal unit 43 comprising a burner 44' and a first combustion chamber portion 46'. The thermal unit 43 is in turn connected to a hot chamber unit 45 which comprises a second combustion chamber portion 46"; finally, the furnace 40 comprises a closing head 42. According to this configuration, the second combustion chamber portion 46" is connected to the first combustion chamber portion 46' in such a way as to increase the extension thereof; this advantageously makes it possible to prolong the exposure to heat of the surfaces of the sandwich 200 which passes through the furnace 40 and therefore also to optimise the thermal capacity of the furnace 40.

Preferably, in both the configurations described above, the various units, i.e. the fume inlet and outlet module 41, the thermal unit 43, the hot chamber unit 45 and the closing head 42, may be contained in a single block or divided into respective - even repeated - modules connected to each other. The modular configuration in particular makes it advantageous to arrange further units comprising burners 44' and/or combustion chambers 46, so that the treatment apparatus 300 can be suitably configured based on the volumes of the elements to be treated.

According to a preferred embodiment of the invention, the burner 44' is of the reverse flame type and is configured such that the flame laps an upper surface of the sandwich 200, i.e., the rear support plate 25, when the sandwich 200 or portions thereof pass through the thermal unit 43. Preferably the burner also makes use of compressed air so that the direction of the flame can be better controlled.

In addition, the system is under suction: air is sucked in through the outlet channel 41".

In a preferred configuration, as shown in Figures 5a and 5b, the fume inlet and outlet module 41 comprises a first channel 41' through which a flow of air is sucked in from the external environment and conveyed towards the burner 44', and a second channel 41" through which the fumes resulting from the combustion implemented by the burner 44', are captured so that they flow towards a filtration system (not shown in the figures) before being reintroduced into the external environment. Preferably, the first channel 41' and the second channel 41" have at least one portion in mutual contact, so that part of the heat of the exhaust fumes is advantageously transferred to the flow of air flowing inside the first channel 41', and carries out a pre-heating of the air that will be used by the burner 44'; in this way, the efficiency of the furnace 40 is conveniently increased, leading among other things to a saving in the amount of gas used to carry out the combustion.

According to one embodiment, a heat exchanger (not shown in the figures) is interposed between the first channel 41' and the second channel 41" so as to further increase the efficiency of the heat exchange between the two channels and consequently the efficiency of the combustion process implemented by means of the furnace 40. For example, a shell and tube heat exchanger, per se known to the skilled person, can be used.

In accordance with some embodiments, the heater device 44 is placed with respect to the surface of the rear support plate 25 at a distance varying between about 30 mm and about 200 mm, preferably the heater device 44 is placed 50 mm from the surface of the rear support plate 25. According to a preferred configuration, the heater device 44 is configured such that the directional flow of heat emitted therefrom hits on the surface of the rear support plate 25 at an angle that may vary between about 30° and about 60°; preferably, the directional flow of heat emitted by the heater device 44 hits on the surface of the rear support plate 25 at an angle of about 45°.

In a preferred configuration, the burner 44' is placed, with respect to the surface of the rear support plate 25, at a distance varying between about 30 mm and about 200 mm; preferably the burner is placed 50 mm from the surface of the rear support plate 25. According to a preferred configuration, the burner 44' is configured such that the flame emitted therefrom hits on the surface of the rear support plate 25 at an angle that may vary between about 30° and about 60°; preferably, the flame emitted by the burner 44' hits on the surface of the rear support plate 25 at an angle of about 45°.

In accordance with other possible embodiments, in addition to or as an alternative to the burner 44', the furnace 40 may comprise different heater devices 44, such as means suitable for generating a directional flow of hot air and/or a flow of infrared rays.

In accordance with some embodiments, the fume inlet and outlet module 41 comprises an afterburner (not shown) adapted to induce the combustion of the fumes exiting the combustion chamber 46. As the skilled person can well understand, the complete combustion of the junction insulating plates 22, 24 and the incomplete combustion of the rear support plate 25 generates fumes which entrain combustible elements with them. In particular, the fumes entrain dusts (mainly carbonaceous particles) and, depending on the operating conditions, unburned organic compounds and/or combustible gaseous fractions (e.g. carbon monoxide). The afterburner is configured, in a per se known manner, to induce the combustion of such combustible elements in the flow of hot gases.

In this embodiment, downstream of the afterburner, a quantity of hot air can be drawn from the main flow destined to be reintroduced into the external environment. The hot air drawn downstream of the afterburner may be directed towards the combustion chamber 46 to feed or support the directional flow of heat emitted by the heater device 44.

Downstream of the furnace 40 and connected to the unloading zone 32 of the feeding device 30, the treatment apparatus 300 has a mechanical separator device 50, for example a comb-like separator 50, which is adapted to separate the metal contacts 23b, formed essentially of copper strips, from the assembly comprising the photovoltaic cells 23a and the glass elements 21'. In more detail, the mechanical separator device 50 may comprise a sliding plane consisting of a plurality of long-shaped lamellae 50' arranged parallel to each other. According to a preferred configuration, the lamellae 50' are spaced apart from each other so as to create passage openings less than or equal to about 50 mm, preferably 25 mm, so as to allow only the transit of the glass elements 21' and silicon elements 23a, falling during the passage of the material in the mechanical separator device 50. Preferably, the lamellae 50' have a longitudinal size of at least 100 mm; according to this configuration the efficiency of the process of separating the metal contacts 23b, which are separated from the material flow by sliding on the lamellae, is ensured.

In a position lower than the mechanical separator device 50 there are a first collecting element 51, into which the metal contacts 23b separated by means of the mechanical separator device 50 fall and are collected, as well as a second collecting element 52, adapted to receive the material exiting the treatment apparatus, deprived of metal contacts 23b, falling from the mechanical separator device 50.

According to one embodiment of the plant 100, there is a device (not shown in the figures) in proximity to the unloading zone 32 adapted to remove the partially combusted elements of the rear support plate 25, so as to separate them from the photovoltaic cells 23. In a preferred embodiment, said device is configured to suck the partially combusted elements of the rear support plate 25.

The plant 100 further comprises, as shown for example in Figures 1 and 2, a separation apparatus 600 which is preferably placed in proximity to at least one treatment apparatus 300, so as to present its own inlet section 61 in proximity to a mechanical separator device 50 related thereto, even more preferably in proximity to the second collection element 52, so as to advantageously facilitate the loading operations of the material contained therein, towards the aforesaid inlet section 61. Such loading operations maybe performed manually by an operator or automatically, by means of an automated loading device not shown in the figures), interposed between the mechanical separator device 50 and the separation apparatus 600, that is by positioning the machines at different heights in such a way that the material without metal contacts 23b, falls directly into the separator, or according to a mixed mode contemplating both the presence of an operator and of an automatic loading device.

The separation apparatus 600 according to the invention, further has a vibrating sieve 62 placed at the inlet section 61, which is configured to provide for a first separation of fragments or powder (generally consisting of glass), having a maximum size of less than or equal to about 2 mm. According to one embodiment, the separation apparatus 600 comprises a longitudinal opening 62', obtained along the planar element 60, in a position lower than the sieve 62, which is configured to allow the passage of the material coming from the filtration implemented by the sieve 62 and convey it to a third collection element 53, which is positioned below the sieve 62 and said longitudinal opening 62'.

The sieve 62 is connected to at least one planar element 60, inclinable with respect to the ground and having an upper surface 60a along which one or more conveyor elements 63 are arranged.

The planar element 60 comprises at least one pair of side guides 64 arranged along edges of the planar element 60, opposed to each other and substantially perpendicular to the upper surface 60a. According to an alternative embodiment of the invention, the side guides 64 are adjustable in inclination with respect to the upper surface 60a and/or in height with respect thereof, so as to have a highly versatile separation apparatus 600 as it can be adapted at will according to the extent as well as morphology of the flow of material to be separated.

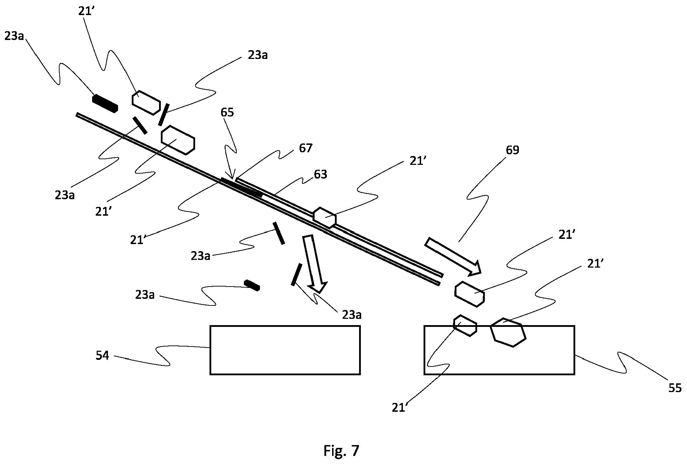

More in detail, as shown in Figures 1, 3 and 7, the planar element 60 has one or more shaped openings 72 in proximity of each of which a respective conveyor element 63, preferably of a substantially laminar shape, is arranged. According to the invention, each conveyor element 63 extends parallel to the planar element 60 and is placed at a substantially constant distance from a plane containing the upper surface 60a of the planar element 60, the value of which is preferably less than or equal to about 2 mm, even more preferably less than or equal to about 1 mm. In this way, a slit 65 is formed, which extends along the perimeter of the conveyor element, between the upper surface 60a of the planar element 60 and the conveyor element 63, which is suitably configured to allow the silicon elements 23a - which generally have a thickness equal to about 200 µm - to be inserted therein and thus to be separated from the glass elements 21'.

Preferably, the conveyor elements 63 are made of sheet metal, having a thickness of at least 2 mm; this allows to ensure the necessary rigidity to prevent any deformations during use over time and to guarantee the parallelism between the conveyor element 63 and the external surface 60a of the planar element 60. According to a preferred embodiment, reinforcing means 71 are present which are adapted to impart rigidity to the planar element 60, so as to avoid undesirable bending and/or deformations thereof; preferably said reinforcing means 71 are placed in a lower position of the planar element 60 and comprise bars connected thereto.

In a position lower than the separation apparatus 600, there is a fourth collection element 54, in which the silicon elements 23a falling below the planar element 60 through the slits 65 are collected, while in proximity to an outlet section 69 there is a fifth collection element 55, into which the glass material falls at the end of its travel along the planar element, once separated from the silicon.

According to a preferred embodiment, the conveyor element 63 has a conformation substantially equivalent to the respective shaped opening with which it is associated. This optimises the opening area from which the silicon 23a can escape, improving the efficiency of the separation process implemented on the separation apparatus 600 and reducing the times to complete the process.

Preferably, the planar element 60 and the conveyor elements 63 are made of a material characterized by a low coefficient of friction such as for example polished metal sheets. In this way, the sliding of the glass 21' and silicon 23a elements along the surface of these elements is facilitated and any blockages or interruptions of the flow of material being processed is conveniently avoided.

In order to further facilitate the sliding on the planar element 60, the latter is preferably held in unidirectional oscillation according to a lateral direction, orthogonal to the direction of the material flow, i.e. orthogonal to the planes on which the side guides 64 lie.

The conveyor elements 63 are connected to the planar element by means of fixing means 66; according to a preferred embodiment of the separation apparatus 600, said fixing means comprise bolts.

Preferably said fixing means 66 are configured in such a way as to allow an adjustment of the distance of the conveyor elements 63 from a plane passing through the upper surface 60a of the planar element 60; in this way, it is advantageously possible to adapt the separation apparatus 600 to the type of photovoltaic panels 2 being processed, in particular based on the sizes of the sandwich 200 with which they are made.

In a preferred embodiment, said fixing means comprise washers and/or shims. In this way, it is advantageously possible to maintain the appropriate distance between the conveyor elements and planar element. Furthermore, this allows the separation apparatus to be advantageously adapted to the type of material being processed.

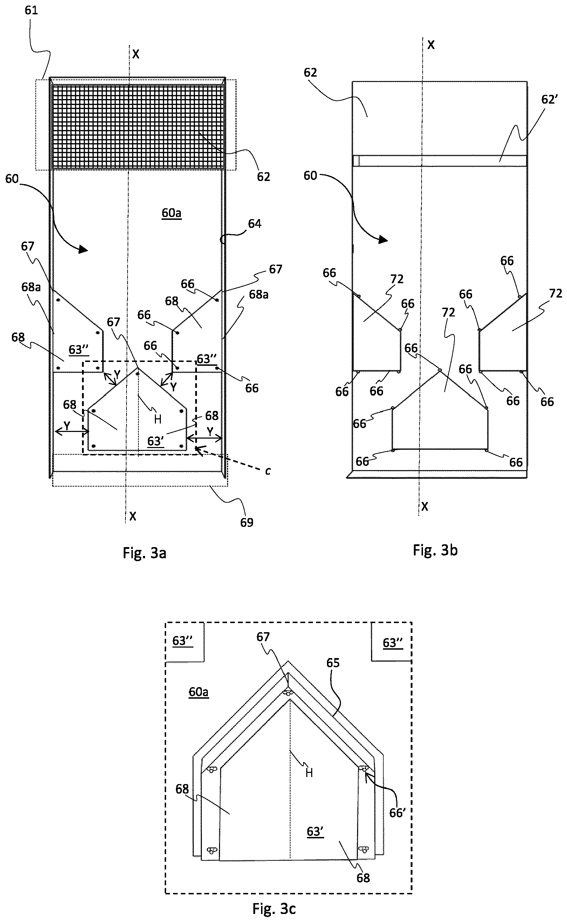

According to a preferred embodiment of the invention, as shown in Figure 3, the separation apparatus 600 comprises at least one central conveyor element 63' and at least two side conveyor elements 63", i.e. arranged in proximity to each side guide 64 respectively, preferably adjacent thereto. According to this configuration, the side conveyor elements 63" make it possible to separate the falling material along the upper surface 60a, and at the same time to guide it towards the central conveyor element 63'.

According to the invention, the separation apparatus 600 is configured in such a way as to optimise the space suitable for the passage of the material to be separated, along the planar element 60; in particular, the conveyor elements 63, 63', 63" are arranged on the planar element 60 in such a way that the clearance Y, present both between each conveyor element 63, 63', 63", as well as between conveyor elements 63, 63' and side guides 64, preferably has a value greater than at least 100 mm.

According to a preferred configuration of the separation apparatus 600, the conveyor elements 63, 63', 63" have a convex polygonal shape, and are arranged on the upper surface 60a preferably so as to present an apex 67 facing towards the inlet section 61. This advantageously facilitates the sliding of the material being processed along the upper surface 60a, so as to avoid unwanted blockages or obstructions of the flow.

In a preferred configuration of the separation apparatus 600, the central conveyor element 63' is conformed according to a convex pentagon formed by the juxtaposition of a pair of rectangular trapezoids 68 along their major base 68a, while the side conveyor elements 63" are conformed according to a rectangular trapezoid 68 having its major base 68a adjacent to the respective side guide 64. Preferably, the side conveyor elements 63" are substantially equivalent to each other as well as to the pair of rectangular trapezoids 68 constituting the central conveyor element 63'.

According to a preferred configuration of the invention, the conveyor elements 63, 63', 63" are positioned along the planar element 60 so that the height H relative to the apex 67 lies on a direction substantially parallel to a longitudinal axis XX of the planar element 60.

Preferably, the oblique side of the rectangular trapezoids 68 forming the central conveyor element 63' has a length greater than or equal to about 25 mm; this configuration conveniently allows to ensure that all photovoltaic cells 23 or portions thereof, are intercepted along the downward path along the planar element 60 and therefore that the glass 21' and silicon 23a elements are efficiently separated.

According to one embodiment, the convex polygon forming the central conveyor elements 63' has segments converging at the apex 67 preferably arranged to form an acute angle *a,* internally to the polygon. Even more preferably the angle *a,* has a value comprised between 20° and 100°.

According to an alternative embodiment of the invention, the planar element 60 has a plurality of central conveyor elements 63' and a plurality of side conveyor elements 63"; preferably the side conveyor elements 63" are in number equal to or greater than the central conveyor elements 63'. According to the invention, whatever the particular configuration of the number of conveyor elements 63, 63', 63" along the planar element 60, a "zig-zag" path is obtained adapted to increase the probability of intercepting the material sliding along the planar element 60, so as to efficiently separate the glass elements from the silicon elements.

In accordance with some embodiments, the separation apparatus 600 further comprises a movement device (not shown in the figures) configured to impose on the planar element 60 an oscillatory motion in its own plane. Preferably, the oscillatory motion is unidirectional, in a lateral direction substantially perpendicular to the longitudinal axis XX of the planar element 60 (see Figure 3). In this way, the advancement of the material along the upper surface 60a of the planar element 60 during the separation step is facilitated.

In accordance with some embodiments, at least one of the conveyor elements 63 is constrained to the planar element 60 in such a way that it can oscillate with respect to the latter in a lateral direction. For example, in the embodiment shown in Figure 3c, the central conveyor element 63' is constrained to the planar element 60 in such a way that it can oscillate with respect to the latter in the lateral direction. By way of example, the fixing means 66' that constrain the central conveyor element 63' to the planar element 60 may comprise elastic elements and/or elongated slots (see Figure 3c) that allow a limited relative movement between the planar element 60 and the central conveyor element 63'. In this way it is possible to prevent silicon elements 23a and/or glass elements 21' from getting caught in the slits 65 obstructing the passage thereof. At the same time, a constant width of the slit is guaranteed over time. The correct functioning of the separation apparatus 600 is thus ensured.

According to the invention, during the separation step, the planar element 60 is placed inclined with respect to the ground, so that a plane passing through its upper surface 60a forms an angle with a plane substantially horizontal to the ground; according to a preferred embodiment, said angle has a value comprised between about 10° and about 45°. Preferably, the separation apparatus 600 comprises means for adjusting the inclination of the planar element 60, so as to be able to adapt the slope thereof, as well as to appropriately increase or decrease the sliding speed of the material subject to the separation step, based on the type of material to be separated.

According to one embodiment as shown in Figure 2, the plant 100 is configured in such a way that the mechanical separator device 50 is placed in a position lower than the inlet section 61 of the separation apparatus 600; in this way, the overall dimensions of the plant 100 are advantageously minimised, in particular in a vertical direction.

The plant 100 may be configured based on the volumes of photovoltaic panels to be recycled, i.e. it is possible to optimise the number of treatment apparatuses 300 and separation apparatuses 600 present in the plant 100, and to manage their interaction appropriately, for example by providing for a plurality of treatment apparatuses 30 feeding separation apparatuses 600, which are present in a smaller number. The plant 100 therefore is conveniently suitable for numerous modifications based on specific management requirements, allowing a decoupling of the apparatuses present therein. This also advantageously simplifies the management of ordinary and extraordinary maintenance operations, e.g. in the event of failures or malfunctions of one or more apparatuses belonging to the plant 100.

According to an alternative embodiment, the second collection element 52 is placed on a plane substantially parallel to the plane containing the inlet section 61 of the separation apparatus 600. In particular, the mechanical separator device 50 can be positioned above said inlet section 61 in such a way that the material exiting the treatment apparatus, deprived of the metal contacts 23b, falls directly into the inlet section 61 of the separation apparatus 600; in this way, the entire recycling process can be carried out continuously, reducing the times required for the completion thereof.

Preferably, at least part of the treatment apparatus 300 and/or at least part of the separation apparatus 600 is placed on respective mobile supports 70; in this manner, it is possible to easily move the apparatus 300, 600 and to obtain a modular and functional plant 100.

Having described the structure of the plant 100, a method 900 for recycling a photovoltaic panel 2 will now be described, according to one embodiment (represented by the flow diagram of Figure 8).

First of all, the frame 20 and the electrical components 26 are removed, so as to free the sandwich 200 of the photovoltaic panel 2.

According to some embodiments, the rear support plate 25 is then cut, substantially through its entire thickness, and obtaining a plurality of adjacent areas substantially over the entire extension of the rear plate 25; such cutting operation only affects the rear support plate 25 and leaves at least one of the junction insulating plates 23, 24 intact, so that the sandwich 200 remains joined and can be managed as a single object. Such operation prior to the introduction of the sandwich into the furnace 40 allows, among other advantages, to improve first of all the speed of the burning process of the junction insulating plates 23, 24.

The sandwich 200 thus treated is preferably positioned on the loading device 33 at the first end portion 34" of the inclined chute 34, arranging it so that the glass plate 21 faces downwards, i.e. resting on the surface of the chute 34. In addition, the panel or part thereof is oriented so that the metal contacts joining the silicon cells are orthogonal to the movement of the belt. By advancing along the chute 34, the sandwich 200 reaches the loading zone 31 and then by translating together with the feeding device 30, moves towards the furnace 40 of which it passes in succession through the fume inlet and outlet module 41, the first unit 43, the hot chamber unit 45 (if any) and the unit 42.

According to one embodiment of the recycling method, the sandwich 200 is directly positioned on the loading zone 31 of the feeding device 30, arranging it so that the glass plate 21 faces downwards.

The portions of the surface which gradually appear at the heater device 44 (for example, the reverse flame burner 44'), are brought to a temperature above 450°C, so as to allow a partial combustion of the areas of the rear plate 25, obtained in the previous step by cutting. The particular modality of the process, as well as the configuration of the furnace 40, in fact, ensure that the flame mainly laps the rear support plate which, as mentioned, is made of fluorinated polymeric material, therefore self-extinguishing; this characteristic, together with the fact that the plate is eventually cut, makes it possible to achieve the complete combustion of the junction insulating sheets 23, 24 (necessary to implement a separation of the various materials), without implementing a complete combustion of the rear support plate 25, thus advantageously avoiding or minimising an emission of hydrofluoric acid in the fumes. In addition thereto, since the rear support plate 25 is loaded with titanium oxide powders (TiO₂), the contamination of the materials, in particular of the glass and of the silicon, is avoided, which would occur if there were a complete combustion.

Therefore, according to these modalities, possibly by preliminarily cutting the rear support plate 25 and by optimising the heat treatment time, it is possible to complete the combustion of the insulating support plates 23, 24, avoiding completing that of the rear support plate 25.

As the skilled person can well understand, the effect of achieving the complete combustion of the insulating support plates 23, 24, while avoiding the complete combustion of the rear support plate 25 may require the setting of different times and temperatures when the specific conditions vary, for example when the thickness and/or material of the rear support plate 25 varies.

In accordance with some embodiments of the invention, the operation of the heater device 44 can be discontinuous, since the combustion of the junction insulating plates 23, 24 can be sufficient to maintain, at least temporarily, the desired temperature inside the furnace 40.

It should be noted in this regard that the characteristic according to which the furnace 40 has a continuous operation does not refer to the fact that the heater device 44 is constantly in operation during the entire operation of the treatment apparatus 300. This characteristic is reported in order to distinguish the furnace 40 from other furnaces with batch operation.

Preferably, the heat treatment time, i.e. the dwell time of the panel 200 inside the modules 43 and 45, is comprised between 3 and 5 minutes.

According to a preferred embodiment of the invention, the areas obtained by cutting the rear support plate 25 are made up of squares having a side of 50 mm; in this way, the polymer constituting said plate 25 contracts, allowing the heat necessary for the combustion of the layers underneath it to penetrate, and consequently enabling a dismemberment of the sandwich 200 and the detachment of the glass 21 from the photovoltaic cells 23.

According to a preferred embodiment of the invention, downstream of the combustion step, preferably in proximity to the unloading zone 32, the possibility to provide for the removal of the partially combusted elements of the rear support plate 25, so as to separate them from the photovoltaic cells 23, for example by means of a suction device, is envisaged.

At the exit from the furnace 40, a mixture of materials is therefore obtained in which the glass 21 is detached from the photovoltaic cells 23; in detail, the mixture of materials comprises glass elements 21', silicon elements 23a and metal contacts 23b. In this step, however, these materials are not yet separated and the partially broken up sandwich 200 still substantially has all the metal contacts 23b parallel to each other; at the exit from the furnace 40, the sandwich 200 is therefore transported by the feeding device 30 towards the unloading zone 32, until it reaches the mechanical separator device 50 which easily separates the metal contacts 23b from the assembly formed by glass and silicon. The glass 21' and silicon 23b elements, as mentioned, are collected in the second collection element 52.

The material thus collected is then conveyed towards the inlet section 61 of the separation apparatus 600 and put onto the sieve 62 which, thanks to a vibratory movement imposed on it by appropriate means, implements a first separation of the fragments of less than 2mm in size which, by falling through the meshes of the sieve 62, are collected in the third collection element 53 placed below the sieve 62.

This operation advantageously allows, according to simple and economical, but at the same time effective, ways, to filter small glass elements 21' up to dust particle sizes, so as to avoid that the finest particles contaminate the silicon cells by passing through the slits 65 or obstruct the slits 65 suitable for glass/silicon separation in the subsequent processing step.

Thanks both to the inclination of the planar element 60 and to the vibration imposed on it, the material previously filtered through the sieve 62 continues its movement by sliding along the external surface 60 of the planar element 60.

As is well known, the sizes of the elements subjected to the separation process varies substantially depending on the nature of the element. In particular, the glass elements 21' have a substantially planar shape the thickness of which is between about 3 mm and about 5 mm, and a surface which varies greatly from one piece to another and which is on average 3 cm². The silicon elements 23a have a similarly planar shape with a similar surface, but differ from the glass pieces 21' in the size of their thickness, which is between 150µm and 300µm (three hundred micrometres).

Therefore, thanks to the correct sizing as well as to the arrangement of one or more conveyor elements 63, 63', 63", it is possible to ensure that the silicon elements 23a are conveyed into the slits 65, during the downward movement of the material along the upper surface 60a of the planar element 60, while the glass elements 21', even if they are crushed into thin pieces, slide above the conveyor elements or are diverted by the conveyor elements and fall into the fourth collection element 54.

Figure 8 schematically illustrates the main steps of a method for recycling (900) photovoltaic panels, which provides for:
- removing (901) the frame 20 and any electrical components 26 from the photovoltaic panel 2, so as to take a sandwich 200 comprising a glass 21, a first junction insulating plate 22, the silicon photovoltaic cells 23, a second junction plate insulator 24 and a rear support plate 25;
- subjecting the sandwich 200 to heat treatment (902) in a furnace 40 until the sandwich 200 is broken up into a first set of materials comprising glass elements 21 ', silicon elements 23a and metal contacts 23b;
- separating (903) the metal contacts 23b mechanical separator 50 so as to obtain a second set of materials comprising glass elements 21' and silicon elements 23a;
- sliding (904) the second set of materials along an inclined planar element 60 having one or more conveyor elements 63, 63', 63" arranged on an upper surface 60a of the planar element so as to form a slit 65 configured to separate the silicon elements 23a from the glass elements 21'.

It is clear from the description above that the plant and method described above will achieve the proposed aims. The separation of the glass from the photovoltaic cells is achieved efficiently by means of a separation plant and apparatus that is simple to construct and low in manufacturing and maintenance costs.

It is clear, however, that many variations can be made by the person skilled in the art without going beyond the scope of protection as set out in the appended claims.

For example, instead of the elements for collecting the various materials during their fall path, it is possible to provide conveyor belts or different chutes according to the material to be collected, so as to transport them to a different station. It is therefore clear that instead of the collection elements represented in the embodiments described above, it is possible to provide different collection means, be they containers, conveyor belts or other.

## Claims

1. Method (900) for recycling photovoltaic panels (2) of the type formed by a frame (20) which encloses a sandwich (200) comprising a glass plate (21) connected to a plurality of photovoltaic cells (23) by means of a first junction insulating plate (22), wherein the photovoltaic cells (23) comprise silicon elements (23a) and metal contacts (23b), the method comprising:
- removing (901) the frame (20) and any electrical components (26) from the photovoltaic panel (2), so as to take a sandwich (200) comprising a glass (21), a first junction insulating plate (22), the photovoltaic cells (23), a second junction insulating plate (24) and a rear support plate (25);
- subjecting the sandwich (200) to heat treatment (902) in a furnace (40) until the sandwich (200) is broken up into a first set of materials comprising glass elements (21'), silicon elements (23a) and metal contacts (23b); and
- separating (903) the metal contacts (23b) from the first set of materials so as to obtain a second set of materials comprising glass elements (21') and silicon elements (23a);
**characterised in that** it further comprises:
- sliding (904) the second set of materials along an inclined planar element (60) having at least one pair of side guides (64) and one or more conveyor elements (63, 63', 63") which are arranged along an upper surface (60a) of the planar element (60) so as to form one or more slits (65) configured to separate the silicon elements (23a) from the glass elements (21').

2. Method according to claim 1, wherein said separating (903) the metal contacts (23b) from the first set of materials comprises conveying said first set of materials towards a mechanical separator device (50) configured to allow the passage of glass elements (21') and silicon elements (23a), so as to separate them from the metal contacts (23b).

3. Method according to claim 1 or 2, wherein the step of sliding (904) the second set of materials along a planar element (60) is preceded by a sifting of said second set, by means of a vibrating sieve (62), configured to provide for a separation of elements having a maximum size of less than or equal to about 2 mm.

4. Method according to any one of the preceding claims, wherein the step of sliding (904) the second set of materials along the inclined planar element (60) comprises the step of oscillating the planar element (60) in a lateral direction.

5. Plant (100) for recycling photovoltaic panels (2) of the type formed by a frame (20) which encloses a sandwich (200) comprising a glass plate (21) connected to a plurality of photovoltaic cells (23) by means of a first junction insulating plate (22), wherein the photovoltaic cells (23) comprise silicon elements (23a) and metal contacts (23b), the plant comprising:
- at least one treatment apparatus (300) extending between a loading zone (31) and an unloading zone (32) and configured to perform an initial break-up of the sandwich (200);
- at least one separation apparatus (600) extending between its own inlet section (61) and its own outlet section (69) and configured to perform a separation of glass elements (21') from silicon elements (23a);
**characterised in that** the separation apparatus (600) comprises an inclinable or inclined planar element (60) having at least one pair of side guides (64) and one or more conveyor elements (63, 63', 63") which are arranged along an upper surface (60a) of the planar element (60) so as to form one or more slits (65) configured to separate the silicon elements (23a) from the glass elements (21').

6. Plant (1) according to claim 5, comprising a comb-like separator device (50), placed downstream of the treatment apparatus (300), and which comprises a plurality of lamellae (50') that are mutually parallel and spaced apart between them so as to form a plurality of openings adapted to allow the passage of the glass elements (21') and silicon elements (23a), so as to separate them from the metal contacts (23b).

7. Plant (1) according to claim 5 or 6, wherein the separation apparatus (600) comprises a vibrating sieve (62), placed at the inlet section (61), and configured so as to provide for a separation of elements having a maximum size of less than or equal to about 2 mm.

8. Plant (1) according to any one of claims 5 to 7, wherein the planar element (60) has one or more openings, in proximity to each of which a respective conveyor element (63, 63', 63") of substantially laminar shape is arranged, which extends parallel to the planar element (60) and is placed at a distance therefrom so as to form a slit (65) which extends along the perimeter of the conveyor element.

9. Plant (1) according to any one of claims 5 to 8, further comprising a movement device configured to impose on the planar element (60) an oscillatory motion in its own plane in a lateral direction perpendicular to a longitudinal axis of the planar element (60).

10. Plant (1) according to any one of claims 5 to 9, wherein the at least one conveyor element (63') is constrained to the planar element (60) in such a way that it can oscillate with respect to the latter in a lateral direction perpendicular to a longitudinal axis of the planar element (60).

11. Separation apparatus (600) for recycling photovoltaic panels (2) of the type formed by a frame (20) that encloses a sandwich (200) comprising a glass plate (21) connected to a plurality of photovoltaic cells (23) by means of a first junction insulating plate (22), wherein the photovoltaic cells (23) comprise silicon elements (23a) and metal contacts (23b), the apparatus (600) being **characterised in that** it comprises at least one inclined or inclinable planar element (60) having at least one pair of side guides (64) and one or more conveyor elements (63, 63', 63") of substantially laminar shape, which are arranged along an upper surface (60a) of the planar element (60) so as to form one or more slits (65) configured to separate the silicon elements (23a) from the glass elements (21').

12. Apparatus (600) according to claim 11, wherein the planar element (60) has one or more openings, in proximity of each of which a respective conveyor element (63, 63', 63") is arranged, which extends parallel to the planar element (60) and is placed at a distance, substantially constant, from a plane containing the upper surface (60a) of the planar element (60), the value of which is less than or equal to about 2 mm.

13. Apparatus (600) according to claim 11 or 12, comprising at least one central conveyor element (63') and at least one pair of side conveyor elements (63"), each of which is arranged on the upper surface (60a) so as to present an apex (67) facing towards the inlet section (61).

14. Apparatus (600) according to any one of claims 11 to 13, further comprising a movement device configured to impose on the planar element (60) an oscillatory motion in its own plane in a lateral direction perpendicular to a longitudinal axis of the planar element (60).

15. Apparatus (600) according to any one of claims 11 to 14, wherein at least one conveyor element (63') is constrained to the planar element (60) in such a way that it can oscillate with respect to the latter in a lateral direction perpendicular to a longitudinal axis of the planar element (60).

## Patentansprüche

1. Verfahren (900) zum Recyceln von Photovoltaik-Modulen (2) des Typs, der durch einen Rahmen (20) gebildet wird, der ein Sandwich (200) umschließt, das eine Glasplatte (21) aufweist, die mit einer Vielzahl von photovoltaischen Zellen (23) mittels einer ersten isolierenden Verbindungsplatte (22) verbunden ist, wobei die photovoltaischen Zellen (23) Siliziumelemente (23a) und Metallkontakte (23b) aufweisen, wobei das Verfahren aufweist:
- Entfernen (901) des Rahmens (20) und jeglicher elektrischer Komponenten (26) vom Photovoltaik-Modul (2), um ein Sandwich (200) zu erhalten, das ein Glas (21), eine erste isolierende Verbindungsplatte (22), die photovoltaischen Zellen (23), eine zweite isolierende Verbindungsplatte (24) und eine rückseitige Trägerplatte (25) aufweist;
- Unterziehen des Sandwichs (200) einer Wärmebehandlung (902) in einem Ofen (40), bis das Sandwich (200) in einer ersten Gruppe von Materialien zerlegt ist, der Glaselemente (21'), Siliziumelemente (23a) und Metallkontakte (23b) aufweist; und
- Trennen (903) der Metallkontakte (23b) von der ersten Gruppe von Materialien, um eine zweite Gruppe von Materialien zu erhalten, die Glaselemente (21') und Siliziumelemente (23a) aufweist;
**dadurch gekennzeichnet, dass** es ferner aufweist:
- Gleiten (904) der zweiten Gruppe von Materialien entlang eines geneigten, ebenen Elements (60) mit mindestens einem Paar von Seitenführungen (64) und einem oder mehreren Förderelementen (63, 63', 63"), die entlang einer oberen Oberfläche (60a) des ebenen Elements (60) angeordnet sind, um einen oder mehrere Schlitze (65) zu bilden, die derart ausgebildet sind, dass sie die Siliziumelemente (23a) von den Glaselementen (21') separieren.

2. Verfahren nach Anspruch 1, wobei das Trennen (903) der Metallkontakte (23b) von der ersten Gruppe von Materialien das Fördern der ersten Gruppe von Materialien zu einer mechanischen Trennvorrichtung (50) umfasst, die derart konfiguriert ist, dass sie den Durchgang von Glaselementen (21') und Siliziumelementen (23a) ermöglicht, um sie von den Metallkontakten (23b) zu trennen.

3. Verfahren nach Anspruch 1 oder 2, wobei dem Schritt des Gleitens (904) der zweiten Gruppe von Materialien entlang eines ebenen Elements (60) eine Aussiebung der zweiten Gruppe mittels eines Vibrationssiebs (62) vorausgeht, das derart gestaltet ist, dass es eine Separierung von Elementen mit einer maximalen Größe von weniger als oder gleich etwa 2 mm bewirkt.

4. Verfahren nach einem der vorhergehenden Ansprüche, wobei der Schritt des Gleitens (904) des zweiten Satzes von Materialien entlang des geneigten, ebenen Elements (60) den Schritt des Oszillierens des ebenen Elements (60) in einer lateralen Richtung umfasst.

5. Anlage (100) zum Recyceln von Photovoltaik-Modulen (2) des Typs, der durch einen Rahmen (20) gebildet wird, der ein Sandwich (200) umschließt, das eine Glasplatte (21) aufweist, die mit einer Vielzahl von photovoltaischen Zellen (23) über eine erste isolierende Verbindungsplatte (22) verbunden ist, wobei die photovoltaischen Zellen (23) Siliziumelemente (23a) und Metallkontakte (23b) aufweisen, wobei die Anlage aufweist:
- mindestens eine Behandlungsvorrichtung (300), die sich zwischen einer Beladungszone (31) und einer Entladungszone (32) erstreckt und derart gestaltet ist, dass sie ein erstes Zerbrechen des Sandwichs (200) vornimmt;
- mindestens eine Trennvorrichtung (600), die sich zwischen ihrem eigenen Einlassabschnitt (61) und ihrem eigenen Auslassabschnitt (69) erstreckt und derart gestaltet ist, dass sie eine Separation von Glaselementen (21') von Siliziumelementen (23a) durchführt;
**dadurch gekennzeichnet, dass** die Trennvorrichtung (600) ein neigbares oder geneigtes ebenes Element (60) mit mindestens einem Paar von Seitenführungen (64) und einem oder mehreren Förderelementen (63, 63', 63") aufweist, die entlang einer oberen Oberfläche (60a) des ebenen Elements (60) angeordnet sind, um einen oder mehrere Schlitze (65) zu bilden, die derart gestaltet sind, dass sie die Siliziumelemente (23a) von den Glaselementen (21') separieren.

6. Anlage (1) nach Anspruch 5, welche eine kammartige Trennvorrichtung (50) aufweist, die stromabwärts der Behandlungsvorrichtung (300) angeordnet ist und die eine Vielzahl von Lamellen (50') aufweist, die zueinander parallel und voneinander beabstandet sind, um eine Vielzahl von Öffnungen zu bilden, die geeignet sind, den Durchgang der Glaselemente (21') und Siliziumelemente (23a) zu ermöglichen, um sie von den Metallkontakten (23b) zu separieren.

7. Anlage (1) nach Anspruch 5 oder 6, wobei die Trennvorrichtung (600) ein Vibrationssieb (62) aufweist, das an dem Einlassabschnitt (61) angeordnet und derart gestaltet ist, dass es eine Separierung von Elementen mit einer maximalen Größe von weniger als oder gleich etwa 2 mm bewirkt.

8. Anlage (1) nach einem der Ansprüche 5 bis 7, wobei das ebene Element (60) eine oder mehrere Öffnungen aufweist, in deren Nähe jeweils ein entsprechendes Förderelement (63, 63', 63") von im Wesentlichen flächiger Form angeordnet ist, das sich parallel zu dem ebenen Element (60) erstreckt und in einem Abstand davon angeordnet ist, so dass ein Schlitz (65) gebildet wird, der sich entlang des Umfangs des Förderelements erstreckt.

9. Anlage (1) nach einem der Ansprüche 5 bis 8, die ferner eine Bewegungseinrichtung aufweist, die derart gestaltet ist, dass sie dem planaren Element (60) eine oszillierende Bewegung in seiner eigenen Ebene in einer seitlichen Richtung senkrecht zu einer Längsachse des planaren Elements (60) erzwingt.

10. Anlage (1) nach einem der Ansprüche 5 bis 9, **dadurch gekennzeichnet, dass** das mindestens eine Förderelement (63') derart durch das flächige Element (60) beschränkt ist, dass es in Bezug auf dieses in einer seitlichen Richtung senkrecht zu einer Längsachse des flächigen Elements (60) oszillieren kann.

11. Trennvorrichtung (600) zum Recyceln von Photovoltaik-Modulen (2) des Typs, der durch einen Rahmen (20) gebildet wird, der ein Sandwich (200) umschließt, das eine Glasplatte (21) aufweist, die mit einer Vielzahl von photovoltaischen Zellen (23) mittels einer ersten isolierenden Verbindungsplatte (22) verbunden ist, wobei die photovoltaischen Zellen (23) Siliziumelemente (23a) und Metallkontakte (23b) aufweisen, wobei die Vorrichtung (600) **dadurch gekennzeichnet ist, dass** sie mindestens ein geneigtes oder neigbares planares Element (60) mit mindestens einem Paar Seitenführungen (64) und einem oder mehreren Förderelementen (63, 63', 63") von im Wesentlichen laminarer Form aufweist, die entlang einer oberen Oberfläche (60a) des planaren Elements (60) angeordnet sind, um einen oder mehrere Schlitze (65) zu bilden, die derart ausgebildet sind, dass sie die Siliziumelemente (23a) von den Glaselementen (21') separieren.

12. Vorrichtung (600) nach Anspruch 11, wobei das ebene Element (60) eine oder mehrere Öffnungen aufweist, in deren Nähe jeweils ein entsprechendes Förderelement (63, 63', 63") angeordnet ist, das sich parallel zu dem ebenen Element (60) erstreckt und in einem im Wesentlichen konstanten Abstand von einer die obere Oberfläche (60a) des ebenen Elements (60) enthaltenden Ebene angeordnet ist, dessen Wert kleiner oder gleich etwa 2 mm ist.

13. Vorrichtung (600) nach Anspruch 11 oder 12, aufweisend mindestens ein zentrales Förderelement (63') und mindestens ein Paar seitlicher Förderelemente (63"), von denen jedes auf der oberen Oberfläche (60a) derart angeordnet ist, dass es einen Scheitelpunkt (67) aufweist, der zum Einlassabschnitt (61) zeigt.

14. Vorrichtung (600) nach einem der Ansprüche 11 bis 13, die ferner eine Bewegungseinrichtung aufweist, die derart gestaltet ist, dass sie dem ebenen Element (60) eine oszillierende Bewegung in seiner eigenen Ebene in einer seitlichen Richtung senkrecht zu einer Längsachse des ebenen Elements (60) aufzwingt.

15. Vorrichtung (600) nach einem der Ansprüche 11 bis 14, bei der mindestens ein Förderelement (63') derart durch das flächige Element (60) beschränkt ist, dass es in Bezug auf dieses in einer seitlichen Richtung senkrecht zu einer Längsachse des flächigen Elements (60) oszillieren kann.

## Revendications

1. - Procédé (900) de recyclage de panneaux photovoltaïques (2) du type formé par un châssis (20) qui renferme un sandwich (200) comprenant une plaque de verre (21) reliée à une pluralité de cellules photovoltaïques (23) au moyen d'une première plaque isolante de jonction (22), les cellules photovoltaïques (23) comprenant des éléments en silicium (23a) et des contacts métalliques (23b), le procédé comprenant :
- retirer (901) du panneau photovoltaïque (2) le châssis (20) et tout composant électrique (26), de façon à prendre un sandwich (200) comprenant un verre (21), une première plaque isolante de jonction (22), les cellules photovoltaïques (23), une seconde plaque isolante de jonction (24) et une plaque de support arrière (25);
- soumettre le sandwich (200) à un traitement thermique (902) dans un four (40) jusqu'à ce que le sandwich (200) soit fragmenté en un premier ensemble de matériaux comprenant des éléments en verre (21'), des éléments en silicium (23a) et des contacts métalliques (23b) ;
- séparer (903) les contacts métalliques (23b) à partir du premier ensemble de matériaux de façon à obtenir un second ensemble de matériaux comprenant des éléments en verre (21') et des éléments en silicium (23a) ;
**caractérisé par le fait qu'**il comprend en outre :
- faire glisser (904) le second ensemble de matériaux le long d'un élément plan incliné (60) ayant au moins une paire de guides latéraux (64) et un ou plusieurs éléments de transport (63, 63', 63") qui sont agencés le long d'une surface supérieure (60a) de l'élément plan (60) de façon à former une ou plusieurs fentes (65) configurées pour séparer les éléments en silicium (23a) des éléments en verre (21').

2. - Procédé selon la revendication 1, dans lequel ladite séparation (903) des contacts métalliques (23b) à partir du premier ensemble de matériaux comprend transporter ledit premier ensemble de matériaux vers un dispositif séparateur mécanique (50) configuré pour permettre le passage d'éléments en verre (21') et d'éléments en silicium (23a), de façon à les séparer des contacts métalliques (23b).

3. - Procédé selon la revendication 1 ou 2, dans lequel l'étape de glissement (904) du second ensemble de matériaux le long d'un élément plan (60) est précédée d'un tamisage dudit second ensemble, au moyen d'un tamis vibrant (62), configuré pour assurer une séparation d'éléments ayant une taille maximale inférieure ou égale à environ 2 mm.

4. - Procédé selon l'une quelconque des revendications précédentes, dans lequel l'étape de glissement (904) du second ensemble de matériaux le long de l'élément plan incliné (60) comprend l'étape d'oscillation de l'élément plan (60) dans une direction latérale.

5. - Installation (100) pour le recyclage de panneaux photovoltaïques (2) du type formé par un châssis (20) qui renferme un sandwich (200) comprenant une plaque de verre (21) reliée à une pluralité de cellules photovoltaïques (23) au moyen d'une première plaque isolante de jonction (22), les cellules photovoltaïques (23) comprenant des éléments en silicium (23a) et des contacts métalliques (23b), l'installation comprenant:
- au moins un appareil de traitement (300) s'étendant entre une zone de chargement (31) et une zone de déchargement (32) et configuré pour réaliser une rupture initiale du sandwich (200) ;
- au moins un appareil de séparation (600) s'étendant entre sa propre section d'entrée (61) et sa propre section de sortie (69) et configuré pour réaliser une séparation d'éléments en verre (21') d'éléments en silicium (23a) ;
**caractérisée par le fait que** l'appareil de séparation (600) comprend un élément plan inclinable ou incliné (60) ayant au moins une paire de guides latéraux (64) et un ou plusieurs éléments de transport (63, 63', 63") qui sont agencés le long d'une surface supérieure (60a) de l'élément plan (60) de façon à former une ou plusieurs fentes (65) configurées pour séparer les éléments en silicium (23a) des éléments en verre (21').

6. - Installation (1) selon la revendication 5, comprenant un dispositif séparateur de type peigne (50), placé en aval de l'appareil de traitement (300), et qui comprend une pluralité de lamelles (50') qui sont mutuellement parallèles et espacées entre elles de façon à former une pluralité d'ouvertures agencées pour permettre le passage des éléments en verre (21') et des éléments en silicium (23a), de façon à les séparer des contacts métalliques (23b).

7. - Installation (1) selon la revendication 5 ou 6, dans laquelle l'appareil de séparation (600) comprend un tamis vibrant (62), placé à la section d'entrée (61), et configuré pour assurer une séparation d'éléments ayant une taille maximale inférieure ou égale à environ 2 mm.

8. - Installation (1) selon l'une quelconque des revendications 5 à 7, dans laquelle l'élément plan (60) a une ou plusieurs ouvertures, à proximité de chacune desquelles se trouve un élément de transport respectif (63, 63', 63") de forme sensiblement laminaire, qui s'étend parallèlement à l'élément plan (60) et est placé à distance de celui-ci de façon à former une fente (65) qui s'étend le long du périmètre de l'élément de transport.

9. - Installation (1) selon l'une quelconque des revendications 5 à 8, comprenant en outre un dispositif de déplacement configuré pour imposer à l'élément plan (60) un mouvement d'oscillation dans son propre plan dans une direction latérale perpendiculaire à un axe longitudinal de l'élément plan (60).

10. - Installation (1) selon l'une quelconque des revendications 5 à 9, dans laquelle l'au moins un élément de transport (63') est contraint à l'élément plan (60) d'une manière telle qu'il peut osciller par rapport à ce dernier dans une direction latérale perpendiculaire à un axe longitudinal de l'élément plan (60).

11. - Appareil de séparation (600) pour le recyclage de panneaux photovoltaïques (2) du type formé par un châssis (20) qui renferme un sandwich (200) comprenant une plaque de verre (21) reliée à une pluralité de cellules photovoltaïques (23) au moyen d'une première plaque isolante de jonction (22), les cellules photovoltaïques (23) comprenant des éléments en silicium (23a) et des contacts métalliques (23b), l'appareil (600) étant **caractérisé par le fait qu'**il comprend au moins un élément plan incliné ou inclinable (60) ayant au moins une paire de guides latéraux (64) et un ou plusieurs éléments de transport (63, 63', 63") de forme sensiblement laminaire, qui sont agencés le long d'une surface supérieure (60a) de l'élément plan (60) de façon à former une ou plusieurs fentes (65) configurées pour séparer les éléments en silicium (23a) des éléments en verre (21').

12. - Appareil (600) selon la revendication 11, dans lequel l'élément plan (60) a une ou plusieurs ouvertures, à proximité de chacune desquelles se trouve un élément de transport respectif (63, 63', 63"), qui s'étend parallèlement à l'élément plan (60) et est placé à une distance, sensiblement constante, d'un plan contenant la surface supérieure (60a) de l'élément plan (60), dont la valeur est inférieure ou égale à environ 2 mm.

13. - Appareil (600) selon la revendication 11 ou 12, comprenant au moins un élément de transport central (63') et au moins une paire d'éléments de transport latéraux (63"), dont chacun est disposé sur la surface supérieure (60a) de façon à présenter un sommet (67) tourné vers la section d'entrée (61).

14. - Appareil (600) selon l'une quelconque des revendications 11 à 13, comprenant en outre un dispositif de déplacement configuré pour imposer à l'élément plan (60) un mouvement d'oscillation dans son propre plan dans une direction latérale perpendiculaire à un axe longitudinal de l'élément plan (60).

15. - Appareil (600) selon l'une quelconque des revendications 11 à 14, dans lequel au moins un élément de transport (63') est contraint à l'élément plan (60) d'une manière telle qu'il peut osciller par rapport à ce dernier dans une direction latérale perpendiculaire à un axe longitudinal de l'élément plan (60).
